# EUROPÄISCHE PATENTANMELDUNG

(11) **EP 1 282 160 A1**
(43) Veröffentlichungstag der Anmeldung: **05.02.2003**
(21) Anmeldenummer: 01118458.7
(22) Anmeldetag: 31.07.2001
(51) Int. Cl.: H01L 21/314, H01L 21/324, H01L 21/318, H01L 21/8242, H01L 29/92

(54) **Verfahren zur Herstellung von Schichten eines Nitrid/Oxid-Dielektrikums**

(71) Anmelder: Infineon Technologies AG, 81669 München (DE)
(72) Erfinder: Bernhardt, Henry, 01099 Dresden (DE); Storbeck, Olaf, 01099 Dresden (DE)
(74) Vertreter: Müller - Hoffmann & Partner

(57) **Zusammenfassung**

Die Erfindung betrifft ein Verfahren zur Herstellung von Schichten eines Nitrid/Oxid-Dielektrikums. Dazu wird zunächst eine Nitridschicht auf einem Substrat erzeugt. Nach der Abscheidung wird die Nitridschicht bei einer Temperatur von mindestens 800°C getempert. Dabei werden Kristallfehler der Nitridschicht ausgeglichen, so dass die Dichte der Schicht zunimmt. Die getemperte Nitridschicht wird anschließend durch Oxidation zumindest teilweise in eine Oxidschicht überführt. Mit dem erfindungsgemäßen Verfahren können Kondensatoren hergestellt werden, welche einen geringeren Leckstrom aufweisen bzw. bei denen eine geringere Schichtdicke des Dielektrikums verwirklicht werden kann.

## Beschreibung

Die Erfindung betrifft ein Verfahren zur Herstellung von Schichten eines Nitrid/Oxid-Dielektrikums, das beispielsweise bei der Herstellung von Kondensatoren in DRAMs angewendet werden kann.

Schichten aus rückoxidierten Node-Nitrid werden beispielsweise als dielektrische Schichten in Deep Trench-Kondensatoren verwendet. Node-Nitrid (Nitrid/Oxid-Dielektrikum) wird hergestellt, indem zunächst eine Nitridschicht erzeugt wird, welche anschließend mit einem Oxidationsmittel zurückoxidiert wird. Bei der Herstellung der Nitridschicht wird so vorgegangen, dass zunächst mit einem nasschemischen Verfahren eine Oxidschicht auf der Oberfläche des Wafers erzeugt wird. Als Oxidationsmittel wird dazu beispielsweise Wasserstoffperoxid verwendet. Anschließend wird die Node-Nitrid-Schicht erzeugt, indem zunächst eine thermische Nitridierung durchgeführt wird. Dazu wird das Substrat mit der Oxidschicht bei einer Temperatur von 950°C mit Ammoniakgas behandelt. Das Ammoniak diffundiert durch die Oxidschicht und reagiert mit dem Silizium des Wafers unter Ausbildung einer Siliziumnitridschicht. Diese Schicht weist eine sehr hohe Dichte auf und ist gegenüber chemischen Veränderungen sehr beständig. Sie kann daher üblicherweise nicht durch Oxidationsmittel oxidiert werden. Die Schichtdicke der Nitridschicht liegt im Bereich von 1,8 nm, wobei keine klare Grenze zwischen der Oxidschicht und der Nitridschicht gebildet wird. Anschließend wird in einem LPCVD-Verfahren (Low Pressure Chemical Vapor Deposition) eine ca. 2,2 nm starke Siliziumnitrid abgeschieden. Das Siliziumnitrid bildet sich durch Reaktion von Dichlorsilan und Ammoniak, welche in der Atmosphäre über dem Siliziumwafer vorliegen. Die gesamte Schichtdicke der Nitridschicht auf den Wafer beträgt nun ungefähr 4 nm. Bei der Rückoxidation wird die durch das LPCVD-Verfahren abgeschiedene Nitridschicht wieder zum größten Teil in eine Oxidschicht überführt. Als Oxidationsmittel wird Wasserdampf verwendet, welcher zum Beispiel in einer Knallgasflamme unter Sauerstoffüberschuss hergestellt wird. Dem Wasserdampf ist als Katalysator eine Säure beigefügt, beispielsweise Chlorwasserstoffgas. Das Nitrid wird bei der Oxidation wieder in ein Oxid umgewandelt, wobei jedoch die Kristallstruktur der Schicht im Wesentlichen erhalten bleibt.

Die Kapazität eines Kondensators ist abhängig von der Schichtdicke des Dielektrikums, wobei mit abnehmender Schichtdicke die Kapazität zunimmt. Gegenläufig nimmt jedoch der Leckstrom, welcher durch das Dielektrikum fließt, zu. Bei den zur Zeit üblichen Strukturgrößen liegt die Stärke der Schicht des Dielektrikums im Bereich von ungefähr 5 nm. Im Zuge der zunehmenden Miniaturisierung von elektronischen Bauelementen nimmt die Fläche des Kondensators und damit auch die Fläche der Schicht des Dielektrikums ab. Durch die Verkleinerung der Fläche des Dielektrikums bzw. des Kondensators nimmt auch dessen Kapazität ab. Um diesen Kapazitätsverlust auszugleichen, wird daher die Schichtdicke der Schicht des Dielektrikums verringert. Dadurch steigt jedoch gleichzeitig der Leckstrom an, so dass durch dieses Wechselspiel die Fläche des Dielektrikums nur bis zu einem gewissen Grenzwert verringert werden kann. Um eine weitere Miniaturisierung der Kondensatoren zu ermöglichen, müssen daher die Eigenschaften der Schicht des Dielektrikums verändert werden, um so bei abnehmender Schichtdicke des Dielektrikums ein Ansteigen des Leckstroms zu vermeiden.

Aufgabe der Erfindung ist es daher, ein Verfahren zur Herstellung von Schichten eines Nitrid/Oxid-Dielektrikums zur Verfügung zu stellen, welches die Herstellung von Kondensatoren erlaubt, welche bei niedrigen Schichtdicken einen geringen Leckstrom zeigen.

Die Aufgabe wird gelöst durch ein Verfahren zur Herstellung von Schichten eines Nitrid/Oxid-Dielektrikums, wobei zunächst durch oxidative Behandlung eine Oxidschicht auf einem Substrat erzeugt wird, anschließend durch thermische Nitridierung eine Nitridschicht auf dem Substrat erzeugt wird, auf der in einem LPCVD-Verfahren weiteres Nitrid abgeschieden wird, um die Schichtdicke der Nitridschicht zu erhöhen; die Nitridschicht nach ihrer Abscheidung bei einer Temperatur von mindestens 800°C getempert wird; und die getemperte Nitridschicht durch Oxidation zumindest teilweise in eine Oxidschicht überführt wird.

Im Gegensatz zu den bisher verwendeten Verfahren umfasst das erfindungsgemäße Verfahren also einen zusätzlichen Temperschritt, der nach der Abscheidung der Nitridschicht durchgeführt wird. Während des Temperns erhöht sich die Dichte der Nitridschicht, indem vermutlich Kristallfehler, die nach der Abscheidung noch vorhanden sind, ausgeglichen werden. Durch die verbesserte Kristallstruktur wird daher bei Kondensatoren, deren Dielektrikum mit dem erfindungsgemäßen Verfahren erzeugt wurde, im Vergleich zu Kondensatoren, die nach bekannten Verfahren hergestellt wurden, bei gleicher Schichtdicke ein geringerer Leckstrom beobachtet. Daher werden bei gleichem Leckstrom auch höhere Kapazitäten beobachtet. Mit dem erfindungsgemäßen Verfahren können daher bei gleichem Leckstrom wie die bisher bekannten Kondensatoren Kondensatoren mit geringeren Abmessungen hergestellt werden. Dies erlaubt eine weitere Miniaturisierung der elektronischen Bauelemente.

Für das Tempern können unterschiedliche Verfahren angewendet werden, wobei bei gleichen Abmessungen des Kondensators Bauelemente erhalten werden können, welche entweder eine erhöhte Kapazität oder einen geringeren Leckstrom aufweisen.

Gemäß einer ersten Ausführungsform des Verfahrens wird zum Tempern das Substrat mit der Nitridschicht unter einer Inertgasatmosphäre erhitzt. Die Umordnung der Kristallstruktur erfolgt hier durch thermische Bewegung der Atome. Das Tempern wird bevorzugt bei einer Temperatur von 900 bis 1200°C, insbesondere bevorzugt 900 bis 1000°C durchgeführt. Der Druck der Inertgasatmosphäre wird bevorzugt im Bereich von 100 bis 105.000 Pa gewählt. Die Zeit, während der das Tempern der Nitridschicht ausgeführt wird, liegt im allgemeinen im Bereich von 10 bis 120 Minuten, vorzugsweise 10 bis 60 Minuten und ist abhängig von der Stärke der abgeschiedenen Nitridschicht.

Gemäß einer zweiten Ausführungsform des Verfahrens wird das Substrat mit der Nitridschicht zum Tempern unter einer Reaktivgasatmosphäre erhitzt. Als Reaktivgas sind alle Verbindungen geeignet, welche ein chemisches Gleichgewicht mit der abgeschiedenen Nitridschicht ausbilden können. Wegen der guten Zugänglichkeit wird das Tempern bevorzugt unter einer Ammoniakatmosphäre durchgeführt. Die Temperatur, welche zum Tempern angewandt wird, liegt bei dieser Ausführungsform des Verfahrens bevorzugt im Bereich von 900 bis 1200°C, insbesondere bevorzugt 900 bis 1000°C. Die Dauer, während der das Tempern durchgeführt wird, wird im Bereich von 10 bis 120 Minuten, vorzugsweise 10 bis 60 Minuten gewählt und ist abhängig von der Schichtdicke der abgeschiedenen Nitridschicht. Der Druck des Ammoniaks in der Gasphase beträgt bevorzugt zwischen 100 und 105.000 Pa.

Gemäß einer weiteren bevorzugten Ausführungsform des Verfahrens wird zum Tempern das Substrat mit der Nitridschicht einem RTP-Verfahren unterworfen. Bei einem RTP-Verfahren (Rapid Thermal Processing) wird das Substrat mit der abgeschiedenen Nitridschicht zunächst mit einer hohen Heizrate aufgeheizt, dann bei der erreichten Temperatur gehalten und danach wieder abgekühlt. Das Verfahren erlaubt sehr kurze Prozessierungszeiten. So wird die erreichte Temperatur meist nur für eine kurze Zeit gehalten. Das Substrat mit der Nitridschicht wird dabei im Allgemeinen mit einer Heizrate von mehr als 30°K/s auf eine Temperatur von mindestens 800°C erhitzt und anschließend in einer Reaktivgasatmosphäre für mindestens 10 Sekunden bei dieser Temperatur gehalten. Anschließend wird das Substrat wieder auf Raumtemperatur abgekühlt. Bevorzugt wird die Abkühlrate von mehr als 30 K/s gewählt. Die Temperatur, bei der das Substrat mit der Nitridschicht getempert wird, wird bevorzugt im Bereich von 800 bis 1400°C, insbesondere bevorzugt 1000 bis 1300°C gewählt. Die Dauer, für die das Substrat mit der Nitridschicht bei erhöhter Temperatur getempert wird, liegt bevorzugt im Bereich von 10 bis 120 Sekunden, insbesondere bevorzugt 10 bis 60 Sekunden. Als Reaktivgas wird bevorzugt Ammoniak verwendet.

In einer bevorzugten Ausführungsform erfolgt das Aufheizen unter einer Inertgasatmosphäre, beispielsweise einer Stickstoffatmosphäre. Nach Erreichen der für das Tempern verwendeten Temperatur wird die Inertgasatmosphäre dann gegen eine Reaktivgasatmosphäre ausgetauscht. Das Verfahren wird dadurch besser kontrollierbar.

Der beim erfindungsgemäßen Verfahren zusätzlich ausgeführte Temperschritt wird bevorzugt entweder direkt nach der Abscheidung der Nitridschicht im dazu verwendeten Ofen durchgeführt, oder unmittelbar vor der Rückoxidation der Nitridschicht im dazu vorgesehenen Ofen.

Mit dem erfindungsgemäßen Verfahren können dichtere Node-Schichten erzeugt werden, welche eine geringere Anzahl von Kristallfehlern aufweisen. Dadurch ergeben sich zwei Wege, auf denen die derzeit hergestellten Kondensatoren von zum Beispiel DRAMs verbessert werden können. Es kann entweder die Schichtdicke des Dielektrikums konstant gehalten werden. In diesem Fall führt der geringere Leckstrom zu einer Verbesserung der Ausbeute bei der Herstellung der Speicherbausteine, da Ausbeuteverluste vermieden werden, die durch hohe Leckströme in Trench-Kondensatoren verursacht werden. Alternativ kann die Dicke der Schicht des Node-Dielektrikums so weit verringert werden, dass die Leckströme in einem unkritischen Bereich gehalten werden. Dies erlaubt die Herstellung dünnerer Schichten aus Node-Dielektrikum und damit die Herstellung von Bauelementen mit geringeren Abmessungen.

Die Erfindung wird unter Bezugnahme auf die beigefügten Figuren und anhand von Beispielen näher erläutert. Dabei zeigt:
- Fig. 1: eine Graphik, in der für eine Anordnung von 10⁶ Kondensatoren die gemessene Kapazität gegen den Leckstrom aufgetragen ist;
- Fig. 2: eine der Fig. 1 entsprechende Darstellung, wobei jeweils der Mittelwert der einzelnen Messungen aufgetragen ist;
- Fig. 3: eine Graphik, bei der die Verteilung der gemessenen Kapazitäten einzelner Kondensatoren, gemittelt aus Segmenten von 30.000 Einzelkondensatoren, für verschiedene Wafer aufgetragen ist.
- Fig. 4: eine Graphik, in welcher für unterschiedliche Wafer der Leckstrom in Abhängigkeit von der angelegten Spannung aufgetragen ist.

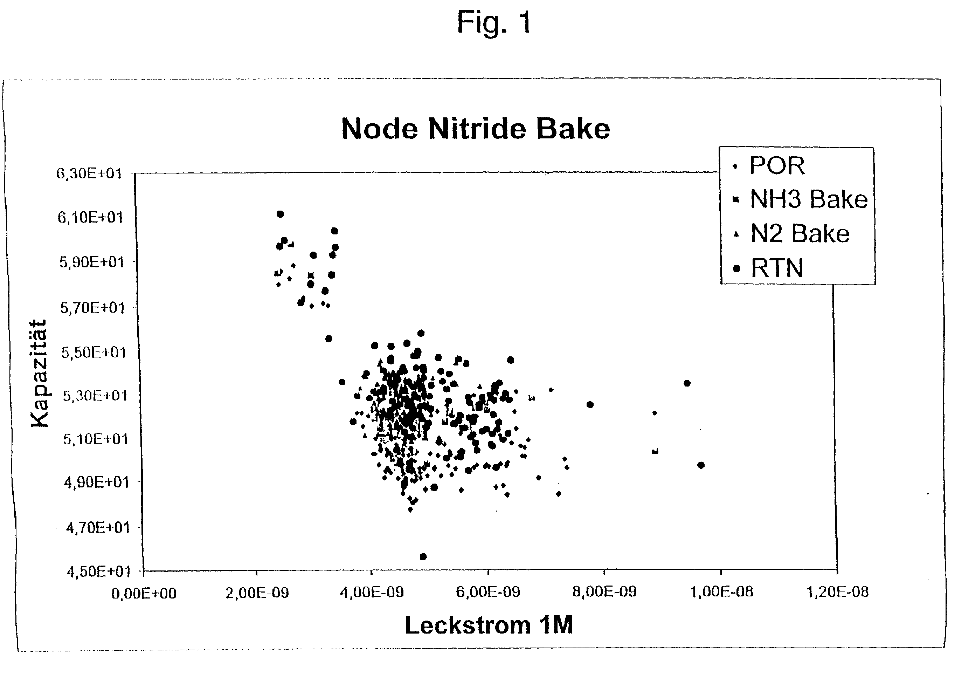

Für die Messungen wurden Wafer hergestellt, auf denen jeweils Felder mit 1000 x 1000 (10⁶) Deep Trench-Kondensatoren angeordnet und verdrahtet waren. Für jede der Anordnungen wurde jeweils die gesamte Kapazität und der gesamte Leckstrom bestimmt. In Fig. 1 sind die mit einer einzelnen Messanordnung gewonnenen Messwerte jeweils für Kondensatoranordnungen dargestellt, deren Dielektrikum jeweils nach verschiedenen Verfahren hergestellt wurde.

Zunächst wurden mittels üblicher Techniken Trenches in einem Siliziumwafer eingeätzt. Anschließend wurde die Oberfläche der Trenches zunächst in einem nasschemischen Verfahren mit Wasserstoffperoxid oxidiert, so dass eine ca. 1 nm dicke Oxidschicht erhalten wurde. Anschließend wurde eine Nitridschicht aufgebracht. Dazu wurde zunächst der Wafer bei einer Temperatur von 950°C und einem Druck von 800 Pa in einer NH₃-Atmosphäre behandelt. Auf den Wafer wurde anschließend im gleichen Reaktor bei einem Druck von 33 Pa (250 mTorr) und einer Temperatur von 700 °C mit Hilfe von Dichlorsilan und NH₃ eine 2,2 nm starke Siliziumnitridschicht abgeschieden. Nach der Abscheidung der Nitridschicht wurden die Siliziumwafer in vier Gruppen aufgeteilt, welche unterschiedlich weiterbehandelt wurden. In einer ersten Gruppe (POR) wurde direkt die Nitridschicht zurückoxidiert. Dazu wurde der Wafer in einen Oxidofen überführt, in dem die Nitridschicht in einer Atmosphäre aus Wasser, Sauerstoff und Chlorwasserstoffgas bis ca. 50 % ihrer Schichtdicke oxidiert wurde. Die Kondensatoren wurden anschließend nach üblichen Verfahren fertiggestellt und verdrahtet und anschließend für jeweils eine Anordnung aus 10⁶ Kondensatoren die Kapazität und der Leckstrom bestimmt.

In einer zweiten Gruppe (NH₃ Bake) wurde nach der Abscheidung der Nitridschicht der Wafer für 30 Minuten in einer NH₃-Atmosphäre auf 950°C erhitzt. Nach Abkühlen wurde der Wafer aus dem Ofen entnommen und die Nitridschicht analog der ersten Gruppe in einem Ofen mit einer Wasser/Sauerstoff/Chlorwasserstoff-Atmosphäre oxidiert.

In einer dritten Gruppe (N₂ Bake) wurde der Wafer nach der Abscheidung der Nitridschicht in einer N₂-Atmosphäre für 30 Minuten auf 950°C erhitzt. Nach Abkühlen auf Raumtemperatur wurde der Wafer entnommen und dann analog der ersten Gruppe die Nitridschicht in einer Wasser/Sauerstoff/Chlorwasserstoff-Atmosphäre zurückoxidiert.

In einer vierten Gruppe (RTN) wurde der Wafer nach der Abscheidung der Nitridschicht in eine RTP-Vorrichtung überführt und unter einer Stickstoff-Atmosphäre mit einer Heizrate von 150°C/s auf eine Temperatur von 1150°C erhitzt. Die N₂-Atmosphäre wurde dann durch NH₃ ersetzt und der Wafer für 45 Sekunden bei 1150°C gehalten. Anschließend wurde der Wafer auf Raumtemperatur abgekühlt und die Nitridschicht wie bei der ersten Gruppe beschrieben in einer Wasser/Sauerstoff/Chlorwasserstoff-Atmosphäre zurückoxidiert.

Um den mit dem oben beschriebenen Verfahren erhaltenen Wafern wurden jeweils 10⁶ Kondensatoren zu einer Messeinheit zusammengefasst und jeweils deren Kapazität sowie der gesamte Leckstrom bestimmt.

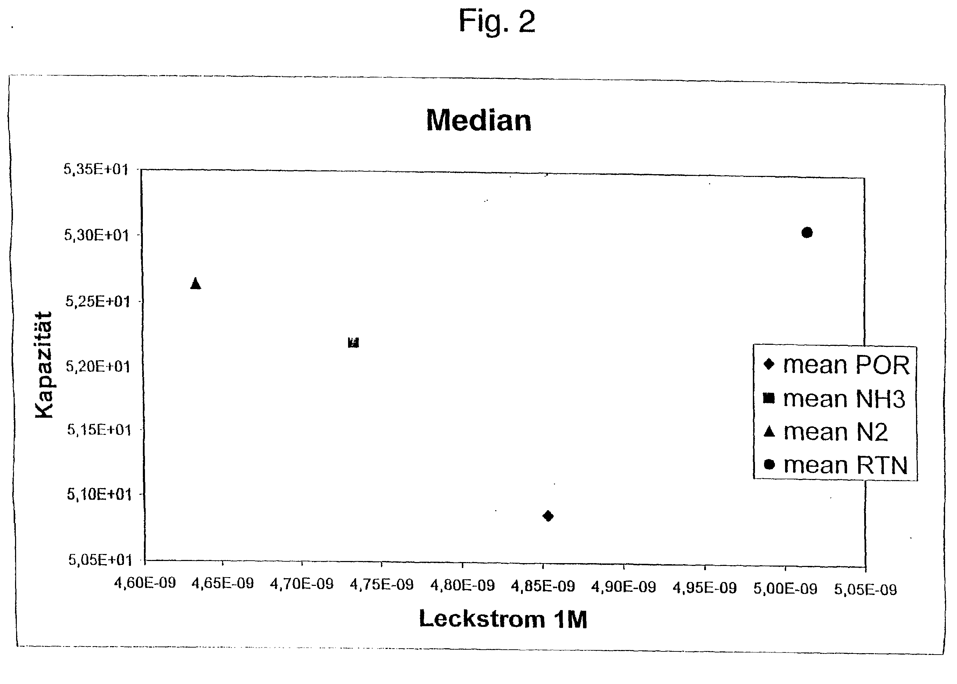

Die für die einzelnen Gruppen erhaltenen Messwerte sind jeweils in Fig. 1 als Punkt dargestellt. Es werden Messwolken erhalten, aus denen jeweils die Mittelwerte für die nach den unterschiedlichen Verfahren hergestellten Kondensatoren ermittelt werden können. Diese Mittelwerte sind in Fig. 2 dargestellt. Wie Fig. 2 zeigt, besitzen die nach den erfindungsgemäßen Verfahrensvarianten hergestellten Kondensatoren eine höhere Kapazität als die nach dem bekannten Verfahren hergestellten Kondensatoren (POR). Die Kondensatoranordnungen, bei denen das Dielektrikum unter einer Ammoniak- oder einer Stickstoffatmosphäre getempert wurde, zeigen außerdem einen geringeren Leckstrom als die nach den bekannten Verfahren hergestellten Kondensatoranordnungen.

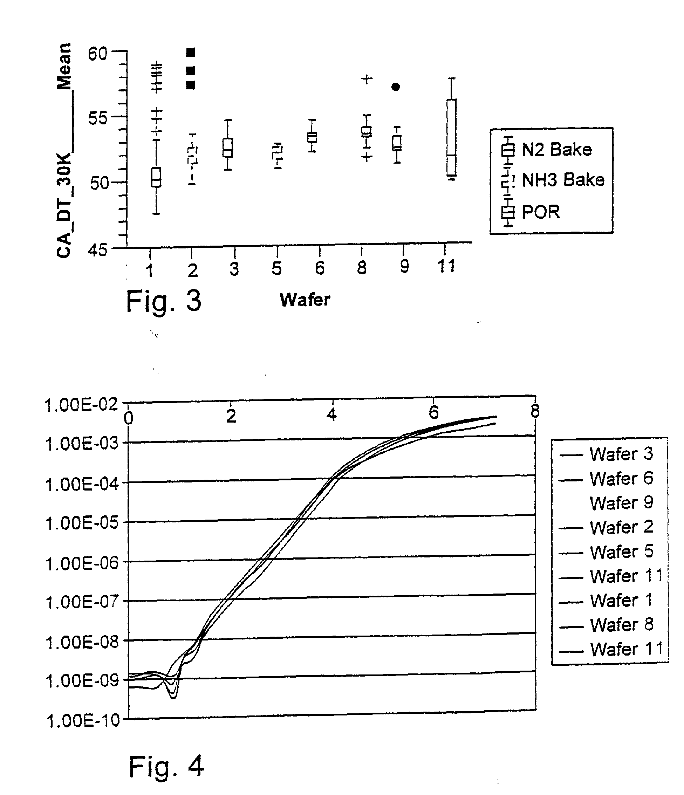

Fig. 3 zeigt eine andere Darstellung der Verteilung der gemessenen Kapazitäten für Wafer, deren Dielektrikum auf unterschiedliche Weise hergestellt wurde. Bei den Wafern 1, 8 und 11 wurde das Dielektrikum nach dem aus dem Stand der Technik bekannten Verfahren hergestellt. Bei den Wafern 2 und 5 wurde die Nitridschicht nach ihrer Abscheidung unter einer Ammoniakatmosphäre bei 950°C für 30 Minuten getempert. Bei den Wafern 3, 6 und 9 wurde die Nitridschicht wie oben beschrieben, für 30 Minuten bei 950°C in einer Stickstoffatmosphäre getempert. In der Darstellung gibt das leere Kästchen jeweils den Bereich der gemessenen Kapazitäten an, welcher 50 % der Messwerte umfasst. Der Median ist jeweils durch einen horizontal verlaufenden Strich angegeben. Der durch eine senkrechte Linie angegebene Bereich entspricht dem Bereich, welcher 98 % der Messwerte erfasst. Messwerte, welche nicht von diesem Bereich erfasst werden, sind jeweils als einzelne Werte angegeben. Die Kondensatoren auf den Wafern 2 bis 6 und 9, welche nach dem erfindungsgemäßen Verfahren hergestellt wurden, zeigen im Median eine höhere Kapazität als die Kondensatoren auf den Wafern 1, 8 und 11.

In Fig. 4 ist jeweils für die gleichen Wafer, wie sie für die Darstellung der Fig. 3 verwendet wurden, der Leckstrom gegen die angelegte Spannung aufgezeichnet. Für alle Wafer steigt der Leckstrom bei einer Spannung von ungefähr 0,9 Volt an, wobei der Anstieg für alle Wafer gleich verläuft. Die Darstellungen der Fig. 3 und 4 zeigen also, dass bei gleichem Leckstrom die Kondensatoren, deren Dielektrikum mit dem erfindungsgemäßen Verfahren hergestellt wurde, eine höhere Kapazität besitzen als die Kondensatoren, die nach bekannten Verfahren hergestellt wurden.

## Patentansprüche

1. Verfahren zur Herstellung von Schichten eines Nitrid/Oxid-Dielektrikums, wobei zunächst durch oxidative Behandlung eine Oxidschicht auf einem Substrat erzeugt wird, anschließend durch thermische Nitridierung eine Nitridschicht auf dem Substrat erzeugt wird, auf der in einem LPCVD-Verfahren weiteres Nitrid abgeschieden wird, um die Schichtdicke der Nitridschicht zu erhöhen; die Nitridschicht nach der Abscheidung bei einer Temperatur von mindestens 800°C getempert wird; und die getemperte Nitridschicht durch Oxidation zumindest teilweise in eine Oxidschicht überführt wird.

2. Verfahren nach Anspruch 1, wobei zum Tempern das Substrat mit der Nitridschicht unter einer Inertgasatmosphäre erhitzt wird.

3. Verfahren nach Anspruch 2, wobei das Inertgas Stickstoff ist.

4. Verfahren nach Anspruch 1, wobei zum Tempern das Substrat mit der Nitridschicht unter einer Reaktivgasatmosphäre erhitzt wird.

5. Verfahren nach Anspruch 4, wobei das Reaktivgas Ammoniakgas ist.

6. Verfahren nach einem der Ansprüche 1 bis 5, wobei das Substrat mit der Nitridschicht für eine Dauer von 10 bis 120 Minuten getempert wird.

7. Verfahren nach Anspruch 1, wobei zum Tempern das Substrat mit der Nitridschicht einem RTP-Verfahren unterworfen wird, wobei das Substrat mit der Nitridschicht mit einer Heizrate von mehr als 30 K/s auf eine Temperatur von mindestens 800°C erhitzt wird, anschließend in einer Reaktivgasatmosphäre für mindestens 10 Sekunden bei dieser Temperatur gehalten wird, und dann auf Raumtemperatur abgekühlt wird.

8. Verfahren nach Anspruch 7, wobei das Aufheizen unter einer Inertgasatmosphäre erfolgt.

9. Verfahren nach einem der Ansprüche 7 oder 8, wobei das Substrat mit der Nitridschicht bei einer Temperatur zwischen 1000°C und 1500°C gehalten wird.

10. Verfahren nach einem der Ansprüche 7 bis 9, wobei die Temperatur für eine Dauer von 10 bis 120 Sekunden gehalten wird.
